# EUROPEAN PATENT APPLICATION

(11) **EP 1 271 163 A1**
(43) Date of publication of application: **02.01.2003**
(21) Application number: 01305360.8
(22) Date of filing: 20.06.2001
(51) Int. Cl.: G01R 31/01, G01R 31/28

(54) **Methods and systems for testing electronic devices**

(71) Applicant: STMicroelectronics Limited, Edinburgh EH12 7BF (GB)
(72) Inventor: Channon, Kevin, c/o STMicroelectronics Ltd, Edinburgh EH12 7BF (GB)
(74) Representative: Cooper, John

(57) **Abstract**

Methods and systems for automatic electronic device testing in which a series of electronic devices (16) are transferred in turn by an input transport mechanism (20) from an input location to a test fixture (22). At least one test stimulus is applied to a first device under test in the test fixture, test output data is obtained from the first device in response to the test stimulus, the test output data is processed to determine a test result and to assign the first device to one of a plurality of output locations (18) selected on the basis of said test result, and the first device is transferred to the selected output location by an output transport mechanism (24). The first device is transferred to the test fixture; at least one test stimulus is applied to the device; test output data is acquired from the device; the device is removed from the test fixture; and the output test data is processed to determine a test result and select an output location for the device while the device is being transferred by the output transport mechanism towards the output locations. During this time, testing of a second device may commence.

## Description

The present invention relates to methods and systems employed in testing integrated circuits (ICs) and populated printed circuit boards (PCBs) including one or more ICs, hereinafter referred to as electronic devices, or simply devices. The invention is particularly applicable to devices comprising or including solid state image sensors, but may also be usefully applied to other types of device, especially of types which require relatively long test cycle times, such as digital signal processors (DSPs).

Typically, conventional electronic device testing systems include automated handling equipment having some form of input means for receiving devices which are to be tested, some form of output means for receiving devices after they have been tested, a test fixture (e.g. a socket or contactor) in which a device is mounted for testing, and one or more transport mechanisms for transporting the devices between the input means, the test fixture and the output means. A conventional system also includes automated test equipment which interfaces with the test fixture for performing tests on the devices and with the transport mechanism(s) to control the transport of devices from the input means to the test fixture and from the test fixture to the output means. The automated test equipment typically also interfaces with a computer workstation or other data processing system.

Generally, devices are tracked through the test system from a specific input location to a specific output location. The output location is generally referred to as a "bin", determined by the result of the test(s) performed by the system, and the process of assigning a device to an output location, on the basis of its test result(s), as "binning". Output bins may be physical locations ("hardware bins") associated with categories of test results in accordance with a predetermined scheme or may be logical locations ("software bins") whereby arbitrary physical locations are mapped to particular devices and categories of test results, or combinations of these.

The testing of a device located in the test fixture generally involves one or more test algorithms which include applying one or more stimuli to the device, acquiring data generated by the device in response to the stimuli, processing the acquired data to determine one or more test results, and determining an output bin for the device on the basis of the test result(s). The test result(s) may indicate that the device should be accepted as "good", rejected as "bad", identified as one of a number of possible device types, or graded according to some variable characteristic of the device. Thereafter, the device is removed from the test fixture and transported to the appropriate output bin by the transport mechanism(s).

In all conventional test systems, the device remains in the test fixture throughout the test process until the appropriate output bin has been determined, and is then transported to the output bin. That is, the test fixture remains occupied by the device until after the data analysis has been completed and the output bin determined. For many types of electronic device, the time required for data analysis is negligible and does not significantly affect the throughput of devices through the system. However, for some types of device, the analysis of test data requires a significant amount of time (comparable to or greater than the test and acquisition time). During this time, the device remains in the test fixture, thus delaying the testing of subsequent devices. This is particularly true of solid state image sensors, where the analysis of test data typically involves processing a number of test images generated by the sensor in response to electronic and/or optical stimuli, and is also true of other types of device requiring complex test algorithms, such as DSPs.

In addition, it may not be possible to assign some types of device to an output bin until all of the test data has been collected and analysed, whereas other types of device may be binned after failure of any one of a series of tests.

It is an object of the present invention to provide improved systems and methods for testing electronic devices of types requiring significant time for processing test data, so as to increase the throughput of devices.

In accordance with a first aspect of the present invention there is provided a method of operating an automatic electronic device testing system of the type in which a series of electronic devices are transferred in turn by an input transport mechanism from an input location to a test fixture, at least one test stimulus is applied to a first device under test in said test fixture, test output data is obtained from the first device in response to said test stimulus, the test output data is processed to determine a test result and to assign the first device to one of a plurality of output locations selected on the basis of said test result, and the first device is transferred to the selected output location by an output transport mechanism, comprising:
transferring said first device to said test fixture;
applying said at least one test stimulus to said first device;
acquiring said test output data from said first device;
removing said first device from said test fixture; and
processing said output test data to determine said test result and select said output location for said first device while said first device is being transferred by said output transport mechanism towards said output locations.

In accordance with a second aspect of the invention there is provided an automatic electronic device testing system of the type comprising an input transport mechanism for transferring a series of electronic devices in turn from an input location to a test fixture, automatic test apparatus for applying at least one test stimulus to said test fixture, acquiring test output data from a first device under test in said test fixture in response to said test stimulus and assigning the first device to one of a plurality of output locations selected on the basis of a test result obtained by processing said output test data, and an output transport mechanism for transferring the first device to the selected output location; wherein:
the system is adapted to remove said first device from said test fixture after said test output data has been acquired and to transfer said first device towards said output locations while the test output data is being processed to determine said test result and select said output location for said first device.

Other aspects and preferred features of the invention are defined in the claims appended hereto.

Embodiments of the invention will now be described, by way of example only, with reference to the accompanying drawings, in which:

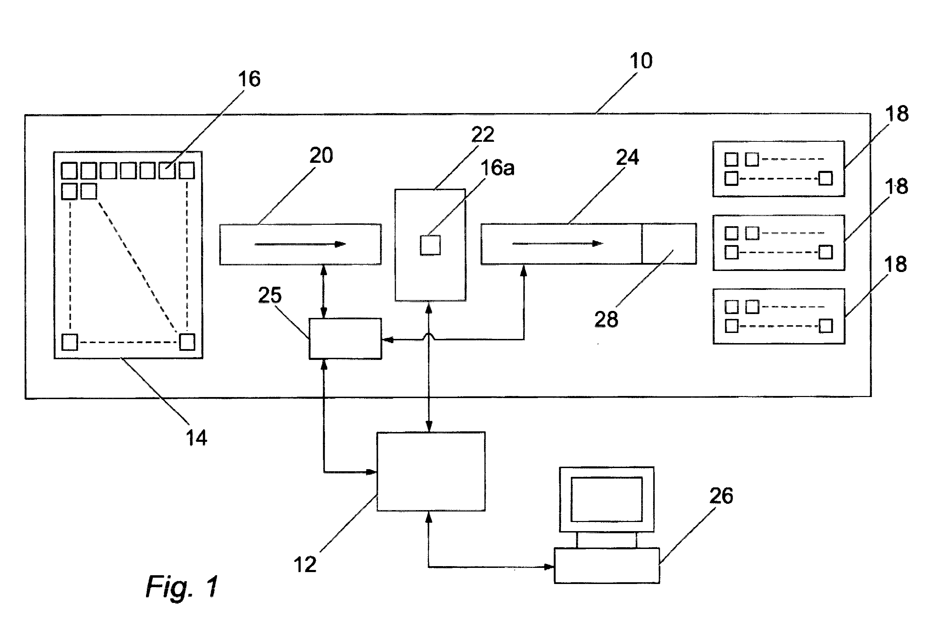

Fig. 1 is a schematic diagram illustrating one embodiment of an automated electronic device testing system in accordance with the present invention.

It will be understood that the present invention may be employed in any of a variety of otherwise conventional electronic device testing systems of the general type described above, which may include different types of input, output and transport mechanisms, and different types of test fixtures, automated test equipment etc. Systems of this general type are well known to those skilled in the art and will not be described in detail herein except insofar as is necessary for an understanding of the present invention.

In particular, it will be understood that batches of electronic devices may be input to and output from test systems using a variety of different packaging types, including trays (such as JEDEC trays), in which devices are arranged in two-dimensional matrices, tube type packages, and tape/reel type packages. Tray type packages are generally preferred for handling image sensors, since there is less chance of damage being caused to optical components of the sensors, and the invention will be described herein by reference to a tray-based system. However, it will be understood that the invention is not limited thereto.

Referring now to the drawings, Fig. 1 schematically illustrates a tray-based electronic device testing system comprising a handler module 10 and an automated test equipment (ATE) module 12. The handler 10 includes an input station adapted to receive at least one input tray 14, containing a plurality of devices 16 which are to be tested, and an output station adapted to accommodate at least one, but typically a plurality of output trays 18, for receiving devices after they have been tested. The handler 10 includes an input transport mechanism 20 for transporting devices from the input tray 14 to a test fixture 22 and an output transport mechanism 24 for transporting devices from the test fixture 22 to the output trays 18. The ATE module 12 is connected to the test fixture for applying test stimuli to a device 16a under test and for acquiring data generated by the device 16a in response to the applied stimuli. The ATE module 12 also communicates with a handler controller 25 in the handler 10, which controls the operation of the transport mechanisms 20 and 24, and is connected to a computer workstation 26 and/or other data processing system(s), which may control the operation of the ATE module and/or receive data downloaded from the ATE module for analysis, etc.

The transport mechanisms 20, 24 may include multiple handling and transport stages between various locations within the handler module 10, and may comprise or include any of a variety of known mechanisms and devices including pick-and-place mechanisms, linear induction motors, hydraulic or pneumatic motors, carousels etc. Fig. 1 shows the input and output transport mechanisms 20 and 24 as being completely separate from one another. However, it will be understood that the transport mechanisms 20 and 24 may share common handling and transport stages for transporting devices between the input tray 14 the test fixture 22 and the output trays 18, depending on the physical layout of the handling module 10 (e.g. the output trays 18 might be located physically adjacent to the input tray 14).

The input transport mechanism may include an alignment stage which ensures that devices being transferred from the input tray 14 are properly aligned for loading into a carrier used to position the device ready for testing, and a loader mechanism which transfers the properly aligned device into the carrier, which may be located on a rotary table or the like for presenting the device to the test fixture. A further mechanism pushes the carrier and the device into engagement with a socket or contactor or the like forming part of the test fixture. The input transport mechanism may further include a thermal preconditioning chamber or the like if required.

Once the device 16a is engaged with the test fixture 22, the ATE module executes the test algorithm(s). This will generally involve applying electronic stimuli to the device 16a. In the case where the device 16a comprises or includes an image sensor, it will also involve the application of optical stimuli. The device 16a generates output data in response to the electronic and/or optical stimuli.

The system described thus far is conventional. In a conventional system, the device 16a would remain in situ in the test fixture whilst the output data from the device 16a is received and processed by the ATE module 12 and/or the workstation 26 (or other data processing means connected to the system). The device 16a would then be assigned to an output bin on the basis of the results of the analysis of the output data, and the output transport mechanism 24 would disengage the device 16a from the test fixture 22 and transport it to an appropriate location in one of the output trays 18.

In accordance with the present invention, once all of the necessary test stimuli have been applied and all of the relevant output data has been output from the device 16a to the ATE module 12, the device 16a is removed from test fixture 22 and the subsequent processing of the output data is carried out whilst the device is in transit between the test fixture and the output trays. The analysis of the output data from the device 16a is completed whilst it is in transit from the test fixture 22 to the output trays 18, the appropriate output bin is determined on the basis of this analysis and communicated to the output transport mechanism 24 by the ATE module 12, and the device is deposited at the appropriate location in the appropriate one of the output trays 18 by the output transport mechanism 24. In this way, the test fixture is vacated and may be occupied by a subsequent device before the processing of the output data from the current device is complete, thereby reducing the overall test cycle time for each device and increasing the throughput of the system.

If the time required for processing the output data from the device 16a under test is less than the time normally required to transport the device from the text fixture 22 to the output trays 18, then the only change to a conventional test system required for the purposes of the present invention is for the ATE module 12 to be programmed to control the handler 10 so as to remove the device 16a currently under test from the test fixture 22 once the required data has been output from the device 16a, and to communicate the required output bin to the output transport mechanism 24 whilst the device 16a is in transit, once the analysis of the output data from the device is complete.

Testing of the subsequent device, including data acquisition therefrom, may commence while the current device is in transit through the output transport mechanism; i.e. while the data acquired from the current device is being processed. In this case, a conventional test system may also have to be modified to allow data to be acquired from the subsequent device while data acquired from the current device is being processed.

The time required for processing the output data from the device 16a may include time required for transferring data from the ATE module 12 to the workstation 26 or other data processing system for analysis thereby, and this data transfer time may in itself be significant. In accordance with the present invention, the removal of the current device from the test fixture and the insertion/testing of the next device may be commenced during this data transfer time.

Depending on the relative times required for processing test output data and for transporting a device from the test fixture 22 to the output trays 18, the operation of the output transport mechanism may be modified to allow time for data processing and binning of each device. The output transport mechanism may comprise a pipeline of multiple stages (which may be able to accommodate a number of devices in transit at one time). In this case, the operation of the various output transport stages can be controlled, dynamically if necessary, to allow the necessary time for data processing and binning of a particular device. For example, the time period between a device being removed from the test fixture 22 and being binned may be varied in multiples of an indexing time associated with one or more stages of the output transport mechanism 24.

Alternatively or additionally, the output transport mechanism may be modified to include one or more holding stations 28, where one or more devices may be held temporarily until processing of the test data is complete and an output bin has been assigned to the device. The holding station(s) 28 may be located at any suitable location(s) within the output transport mechanism, such as adjacent to the output trays 18. The holding station 28 could, for example, comprise one or more locations for holding one or more devices, and an associated pick-and-place mechanism for transferring devices between one or more transport devices forming part of the output transport mechanism 24 or between a transport device and the output trays 18. The pick-and-place mechanism could be associated exclusively with the holding station 28 or could be shared with other parts of the input and/or output transport mechanisms (provided this does not interfere with the flow of other devices).

The test algorithms applied to devices may include multiple testing stages. For example, an image sensor or DSP may be subject to basic electrical functionality tests before more complex test algorithms are applied. If a device fails an initial basic test, subsequent complex testing may be unnecessary. In this case, a device currently under test may be "failed" whilst a preceding device is still in transit or held in the output transport mechanism awaiting completion of data processing and binning. In this event, the present invention may allow a current device to "overtake" a preceding device. The current device may physically overtake the preceding device, e.g. where the preceding device is held in a holding station, or may simply have an output bin assigned prior to the preceding device, while following the preceding device through the output transport mechanism.

The invention is applicable to testing devices in single or in parallel configurations. However, in parallel testing of multiple devices, where groups of devices are processed as a single unit and in which some devices may be potential "passes" and others may be known "fails", the improvement in throughput obtained by use of the invention will not be as significant as in systems where single devices are processed in series.

Improvements and modifications may be incorporated without departing from the scope of the invention, as defined in the appended claims.

## Claims

1. A method of operating an automatic electronic device testing system of the type in which a series of electronic devices are transferred in turn by an input transport mechanism from an input location to a test fixture, at least one test stimulus is applied to a first device under test in said test fixture, test output data is obtained from the first device in response to said test stimulus, the test output data is processed to determine a test result and to assign the first device to one of a plurality of output locations selected on the basis of said test result, and the first device is transferred to the selected output location by an output transport mechanism, comprising:
transferring said first device to said test fixture;
applying said at least one test stimulus to said first device;
acquiring said test output data from said first device;
removing said first device from said test fixture; and
processing said output test data to determine said test result and select said output location for said first device while said first device is being transferred by said output transport mechanism towards said output locations.

2. A method as claimed in claim 1, including transferring a second device to said test fixture once the test fixture has been vacated by said first device.

3. The method of claim 2, including commencing testing of said second device while the first device is in transit through the output transport mechanism.

4. A method as claimed in any preceding claim, including controlling operation of said output transport mechanism so as to allow time for the processing of said output test data to be completed while the first device is in transit through the output transport mechanism.

5. A method as claimed in any preceding claim, wherein the test data is acquired from the first device by an automated testing module and the processing of said data includes transferring the data from the automated testing module to a data processing system for analysis, and wherein the first device is removed from said test fixture while said test data is being transferred to said data processing system.

6. A method as claimed in any preceding claim, wherein more than one device is in transit through the output transport mechanism at any given time.

7. A method as claimed in claim 6, wherein data acquired from more than one device in transit through the output transport mechanism is processed simultaneously.

8. A method as claimed in any preceding claim, wherein the output transport mechanism includes at least one holding station for temporarily holding at least one device in transit through the output transport mechanism, and including holding said first device in said holding station while processing of said output test data is completed.

9. A method as claimed in any preceding claim, wherein the testing of each device includes a plurality of testing stages and wherein a test result may be determined after any one of said stages, including selecting an output location for a second device before selecting an output location for the first device if a test result for the second device is determined before a test result for the first device.

10. A method as claimed in claim 9, including transferring said second device to its selected output location before said first device.

11. An automatic electronic device testing system of the type comprising an input transport mechanism for transferring a series of electronic devices in turn from an input location to a test fixture, automatic test apparatus for applying at least one test stimulus to said test fixture, acquiring test output data from a first device under test in said test fixture in response to said test stimulus and assigning the first device to one of a plurality of output locations selected on the basis of a test result obtained by processing said output test data, and an output transport mechanism for transferring the first device to the selected output location; wherein:
the system is adapted to remove said first device from said test fixture after said test output data has been acquired and to transfer said first device towards said output locations while the test output data is being processed to determine said test result and select said output location for said first device.

12. A system as claimed in claim 11, wherein the system is adapted to transfer a second device to said test fixture once the test fixture has been vacated by said first device.

13. A system as claimed in claim 12, wherein the system is adapted to commence testing of said second device while the first device is in transit through the output transport mechanism.

14. A system as claimed in any of claims 11 to 13, wherein the system is adapted to control operation of said output transport mechanism so as to allow time for the processing of said output test data to be completed while the first device is in transit through the output transport mechanism.

15. A system as claimed in any of claims 11 to 14, wherein the automatic test apparatus is adapted to transfer test data acquired from the first device to a data processing system for analysis thereof, wherein the processing of said data includes transferring the data from the automatic testing apparatus to the data processing system, and wherein the system is adapted to remove the first device from said test fixture while said test data is being transferred to said data processing system.

16. A system as claimed in any of claims 11 to 15, wherein the output transport mechanism is adapted to accommodate more than one device in transit therethrough at any given time.

17. A system as claimed in claim 16, adapted so that data acquired from more than one device in transit through the output transport mechanism may be processed simultaneously.

18. A system as claimed in any of claims 11 to 17, wherein the output transport mechanism includes at least one holding station for temporarily holding at least one device in transit through the output transport mechanism.

19. A system as claimed in any of claims 11 to 18, wherein the testing of each device includes a plurality of testing stages and wherein a test result may be determined after any one of said stages, the system being adapted to select an output location for a second device before selecting an output location for the first device if a test result for the second device is determined before a test result for the first device.

20. A system as claimed in claim 19, wherein the system is adapted to transfer said second device to its selected output location before said first device.
